# EUROPEAN PATENT APPLICATION

(11) **EP 4 568 435 A1**
(43) Date of publication of application: **11.06.2025**
(21) Application number: 23863387.9
(22) Date of filing: 22.08.2023
(51) Int. Cl.: H05K 7/20, H04M 1/02, F16C 11/04, G06F 1/16

(54) **ELECTRONIC DEVICE INCLUDING STRUCTURE FOR DISSIPATING HEAT GENERATED IN ELECTRONIC DEVICE**

(30) Priority: 08.09.2022 KR 20220114050; 11.10.2022 KR 20220130101
(71) Applicant: Samsung Electronics Co., Ltd., Suwon-si, Gyeonggi-do 16677 (KR)
(72) Inventor: JUNG, Hyeran, Suwon-si Gyeonggi-do 16677 (KR); KANG, Seunghoon, Suwon-si Gyeonggi-do 16677 (KR); PARK, Yoonsun, Suwon-si Gyeonggi-do 16677 (KR)
(74) Representative: HGF
(86) International application number: PCT/KR2023/012447
(87) International publication number: WO 2024/053911

(57) **Abstract**

An electronic device according to an embodiment comprises: a hinge structure which includes a first hinge plate, a second hinge plate rotatable with respect to the first hinge plate, and a third hinge plate separated from the second hinge plate and rotatable with respect to the first hinge plate; a display; a layer which is attached to the display and includes a first heat dissipation member comprising a first segment, a second segment spaced apart from the first segment, and a plurality of third segments disposed between the first segment and the second segment and spaced apart from each other; and a first conductive member, wherein the first conductive member overlaps a part of the first segment and a part of the second segment in an unfolded state of the electronic device.

## Description

### [Technical Field]

Various embodiments of the present disclosure relate to an electronic device including a structure for dissipating heat generated in the electronic device.

### [Background Art]

There is an increasing need for an electronic device in which a size of a display for displaying content may be changed, so that a user may be provided with various contents through the electronic device. For example, the electronic device may provide a structure in which the size of the display for displaying the content may be changed, as the electronic device includes a foldable flexible display.

### [Disclosure]

### [Technical Solution]

An electronic device according to an embodiment may comprise a hinge structure including a first hinge plate, a second hinge plate rotatable with respect to the first hinge plate, and a third hinge plate distinct from the second hinge plate and rotatable with respect to the first hinge plate. According to an embodiment, the electronic device may comprise a display, disposed on the hinge structure, foldable by movement of the second hinge plate and the third hinge plate with respect to the first hinge plate. According to an embodiment, the electronic device may comprise a layer, attached to the display, including a first heat dissipation member that includes a first segment, a second segment spaced apart from the first segment, and a plurality of third segments disposed between the first segment and the second segment and spaced apart from each other. According to an embodiment, the electronic device may comprise a first conductive member attached on a surface of the first hinge plate facing the plurality of third segments. According to an embodiment, in an unfolded state of the electronic device in which a direction in which a surface of the second hinge plate faces is the same as a direction in which a surface of the third hinge plate faces, when the display is viewed in a second direction opposite to a first direction in which the surface of the first hinge plate faces, the first conductive member may overlap a portion of the first segment and a portion of the second segment.

An electronic device according to an embodiment may comprise a hinge structure including a hinge bracket, a first hinge plate rotatable with respect to the hinge bracket, and a second hinge plate distinct from the first hinge plate and rotatable with respect to the hinge bracket. According to an embodiment, the electronic device may comprise a display, disposed on the hinge structure, being foldable by movement of the first hinge plate and the second hinge plate with respect to the hinge bracket. According to an embodiment, the electronic device may comprise a layer, attached to the display, including a first heat dissipation member that includes a first segment, a second segment spaced apart from the first segment, and a plurality of third segments disposed between the first segment and the second segment, and spaced apart from each other. According to an embodiment, the electronic device may comprise a first conductive member attached on a surface of the first hinge plate facing the layer. According to an embodiment, the electronic device may comprise a second conductive member attached on a surface of the second hinge plate facing the layer. According to an embodiment, in an unfolded state of the electronic device in which a direction in which the surface of the first hinge plate faces is the same as a direction in which the surface of the second hinge plate faces, when the display is viewed in a second direction opposite to a first direction in which the surface of the first hinge plate faces, a portion of the plurality of third segments may overlap the first conductive member and the second conductive member.

### [Description of the Drawings]

FIG. 1 is a block diagram of an electronic device in a network environment according to various embodiments.
FIG. 2A illustrates an example of an unfolded state of an exemplary electronic device according to an embodiment.
FIG. 2B illustrates an example of a folded state of an exemplary electronic device according to an embodiment.
FIG. 2C is an exploded view of an exemplary electronic device according to an embodiment.
FIG. 3A is a top plan view of an exemplary electronic device according to an embodiment.
FIG. 3B is a cross-sectional view illustrating an example of an exemplary electronic device in an unfolded state, cut along line A-A' of FIG. 3A.
FIG. 3C is a cross-sectional view illustrating an example of an exemplary electronic device in a folded state, cut along line A-A' of FIG. 3A.
FIG. 4A is a cross-sectional view illustrating an example of cutting an exemplary electronic device in an unfolded state.
FIG. 4B is a cross-sectional view illustrating an example of cutting an exemplary electronic device in a folded state.
FIG. 5A is a cross-sectional view illustrating an example of cutting an exemplary electronic device in an unfolded state.
FIG. 5B is a cross-sectional view illustrating an example of cutting an exemplary electronic device in a folded state.

### [Mode for Invention]

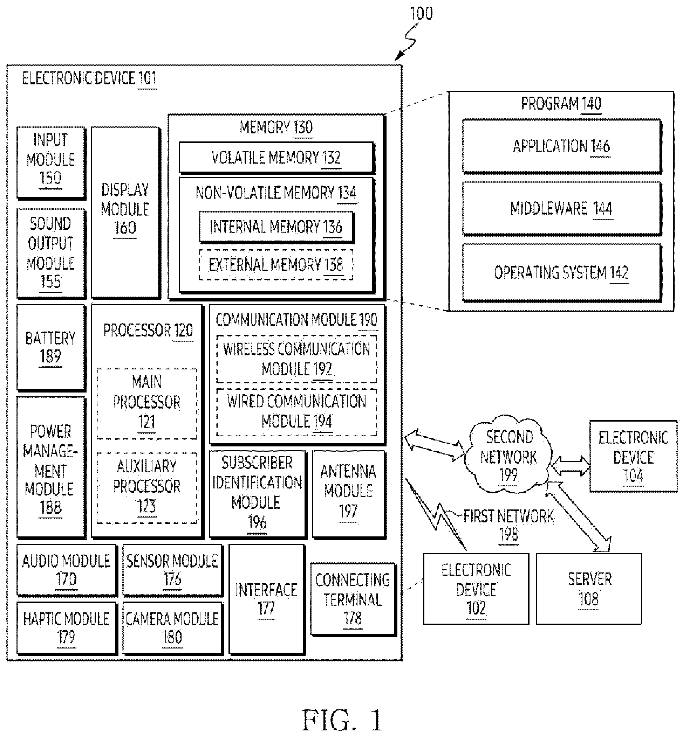

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

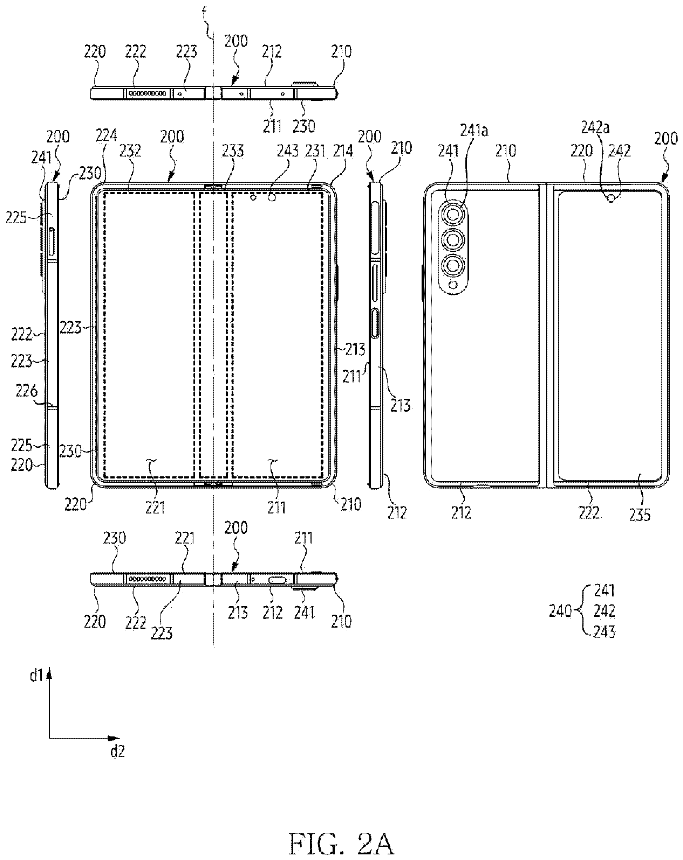

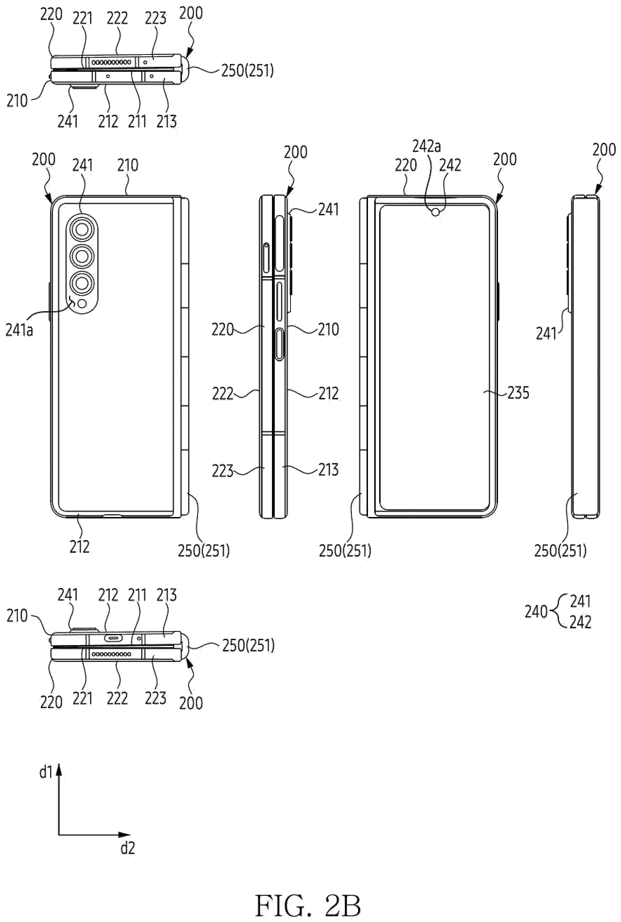

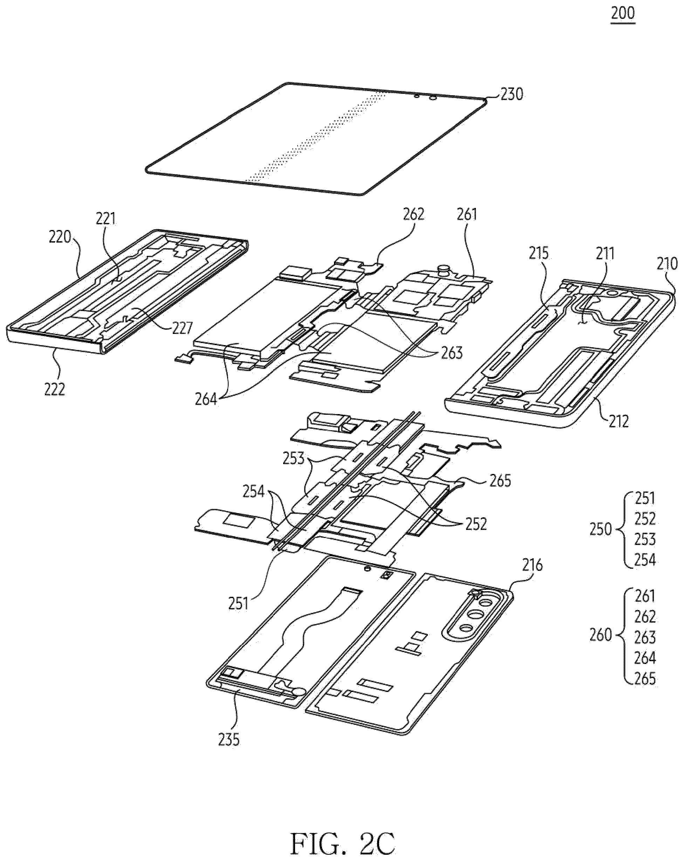

FIG. 2A illustrates an example of an unfolded state of an electronic device according to an embodiment, FIG. 2B illustrates an example of a folded state of an electronic device according to an embodiment, and FIG. 2C is an exploded view of an electronic device according to an embodiment.

Referring to FIG. 2A, FIG. 2B, and FIG. 2C, an electronic device 200 (e.g., the electronic device 101 of FIG. 1) may include a first housing 210, a second housing 220, a display 230 (e.g., the display module 160 of FIG. 1), at least one camera 240 (e.g., the camera module 180 of FIG. 1), a hinge structure 250, and/or at least one electronic component 260.

The first housing 210 and the second housing 220 may form at least a portion of an outer surface of the electronic device 200 that may be gripped by a user. The at least a portion of the outer surface of the electronic device 200 defined by the first housing 210 and the second housing 220, may contact a part of a body of the user when the electronic device 200 is used by the user. According to an embodiment, the first housing 210 may include a first surface 211, a second surface 212 facing the first surface 211 and spaced apart from the first surface 211, and a first side surface 213 surrounding at least a portion of the first surface 211 and the second surface 212. The first side surface 213 may connect a periphery of the first surface 211 to a periphery of the second surface 212. The first surface 211, the second surface 212, and the first side surface 213 may define an inner space of the first housing 210. According to an embodiment, the first housing 210 may provide a space formed by the first surface 211, the second surface 212, and the first side surface 213 as a space for disposing components of the electronic device 101.

According to an embodiment, the second housing 220 may include a third surface 221, a fourth surface 222 facing the third surface 221 and spaced apart from the third surface 221, and a second side surface 223 surrounding at least a portion of the third surface 221 and the fourth surface 222. The second side surface 223 may connect a periphery of the third surface 221 to a periphery of the fourth surface 222. The third surface 221, the fourth surface 222, and the second side surface 223 may define an inner space of the second housing 220. According to an embodiment, the second housing 220 may provide a space formed by the third surface 221, the fourth surface 222, and the second side surface 223 surrounding at least a portion of the third surface 221 and the fourth surface 222, as a space for mounting the components of the electronic device 101. According to an embodiment, the second housing 220 may be coupled to the first housing 210 to be rotatable with respect to the first housing 210.

According to an embodiment, each of the first housing 210 and the second housing 220 may include a first protective member 214 and a second protective member 224, respectively. The first protective member 214 and the second protective member 224 may be disposed on the first surface 211 and the third surface 221 along a periphery of the display 230. According to an embodiment, the first protective member 214 and the second protective member 224 may prevent an inflow of a foreign matter (e.g., dust or moisture) through a gap between the display 230, and the first housing 210 and the second housing 220. For example, the first protective member 214 may surround a periphery of a first display area 231 of the display 230, and the second protective member 224 may surround a periphery of a second display area 232 of the display 230. The first protective member 214 may be formed by being attached to the first side surface 213 of the first housing 210, or may be formed integrally with the first side surface 213. The second protective member 224 may be formed by being attached to the second side surface 223 of the second housing 220, or may be integrally formed with the second side surface 223.

According to an embodiment, the first side surface 213 and the second side surface 223 may include a conductive material, a non-conductive material, or a combination thereof. For example, the second side surface 223 may include at least one conductive member 225 and at least one non-conductive member 226. The at least one conductive member 225 may include a plurality of conductive members respectively spaced apart from each other. The at least one non-conductive member 226 may be disposed between the plurality of conductive members. The plurality of conductive members may be disconnected from each other by the at least one non-conductive member 226 disposed between the plurality of conductive members. According to an embodiment, the plurality of conductive members and a plurality of non-conductive members may form an antenna radiator together. The electronic device 200 may communicate with an external electronic device through the antenna radiator formed by the plurality of conductive members and the plurality of non-conductive members.

The display 230 may be configured to display visual information. According to an embodiment, the display 230 may be disposed on the first surface 211 of the first housing 210 and the third surface 221 of the second housing 220, across the hinge structure 250. For example, the display 230 may include the first display area 231 disposed on the first surface 211 of the first housing, the second display area 232 disposed on the third surface 221 of the second housing, and a third display area 233 disposed between the first display area 231 and the second display area 232. The first display area 231, the second display area 232, and the third display area 233 may form a front surface of the display 230. According to an embodiment, the display 230 may further include a sub-display panel 235 disposed on the fourth surface 222 of the second housing 220. For example, the display 230 may be referred to as a flexible display. According to an embodiment, the display 230 may include a window exposed toward an outside of the electronic device 200. The window may protect a surface of the display 230, and transmit visual information provided by the display 230 to the outside of the electronic device 200 by including a substantially transparent material. For example, the windows may include glass (e.g., ultra-thin glass (UTG)) and/or a polymer (e.g., polyimide (PI)), but it is not limited thereto.

The at least one camera 240 may be configured to obtain an image based on receiving light from a subject outside the electronic device 200. According to an embodiment, the at least one camera 240 may include first cameras 241, a second camera 242, and a third camera 243. The first cameras 241 may be disposed in the first housing 210. For example, the first cameras 241 may be disposed inside the first housing 210, and at least a portion of the first cameras 241 may be visible through the second surface 212 of the first housing 210. The first cameras 241 may be supported by a bracket (not illustrated) in the first housing 210. The first housing 210 may include at least one opening 241a overlapping the first cameras 241 when the electronic device 200 is viewed from above. The first cameras 241 may obtain an image based on receiving the light from the outside of the electronic device 200 through the at least one opening 241a.

According to an embodiment, the second camera 242 may be disposed in the second housing 220. For example, the second camera 242 may be disposed inside the second housing 220, and may be visible through the sub-display panel 235. The second housing 220 may include the at least one opening 242a overlapping the second camera 242 when the electronic device 200 is viewed from above. The second camera 242 may obtain an image based on receiving the light from the outside of the electronic device 200 through the at least one opening 242a.

According to an embodiment, the third camera 243 may be disposed in the first housing 210. For example, the third camera 243 may be disposed inside the first housing 210, and at least a portion of the third camera 243 may be visible through the first surface 211 of the first housing 210. For another example, the third camera 243 may be disposed inside the first housing 210, and at least a portion of the third camera 243 may be visible through the first display area 231 of the display 230. The first display area 231 of the display 230 may include at least one opening (not illustrated) overlapping the third camera 243 when the display 230 is viewed from above. The third camera 243 may obtain an image based on receiving the light from an outside of the display 230 through the at least one opening.

According to an embodiment, the second camera 242 and the third camera 243 may be disposed below (e.g., in a direction facing the inside of the first housing 210 or the inside of the second housing 220) the display 230. For example, the second camera 242 and the third camera 243 may be an under display camera (UDC). In case that the second camera 242 and the third camera 243 are under-display cameras, an area of the display 230 corresponding to each position of the second camera 242 and the third camera 243 may not be an inactive area. The inactive area of the display 230 may mean an area of the display 230 that does not include a pixel or does not emit the light to the outside of the electronic device 200. For another example, the second camera 242 and the third camera 243 may be a punch hole camera. In case that the second camera 242 and the third camera 243 are punch hole cameras, an area of the display 230 corresponding to each position of the second camera 242 and the third camera 243 may be the inactive area.

According to an embodiment, the hinge structure 250 may rotatably connect the first housing 210 and the second housing 220. The hinge structure 250 may be disposed between the first housing 210 and the second housing 220 of the electronic device 101 so that the electronic device 200 may be bent, curved, or folded. For example, the hinge structure 250 may be disposed between a portion of the first side surface 213 and a portion of the second side surface 223 facing each other. The hinge structure 250 may change the electronic device 200 to an unfolding state in which a direction in which the first surface 211 of the first housing 210 faces and a direction in which the third surface 221 of the second housing 220 faces are the same, or a folding state in which the first surface 211 and the third surface 221 face each other. When the electronic device 200 is in the folded state, the first housing 210 and the second housing 220 may be stacked or overlapped by facing each other.

According to an embodiment, when the electronic device 200 is in the folded state, the direction in which the first surface 211 faces and the direction in which the third surface 221 faces may be different from each other. For example, when the electronic device 200 is in the folded state, the direction in which the first surface 211 faces and the direction in which the third surface 221 faces may be opposite to each other. For another example, when the electronic device 200 is in the folded state, the direction in which the first surface 211 faces and the direction in which the third surface 221 faces may be inclined with respect to each other. In case that the direction in which the first surface 211 faces is inclined with respect to the direction in which the third surface 221 faces, the first housing 210 may be inclined with respect to the second housing 220.

According to an embodiment, the electronic device 200 may be foldable with respect to a folding axis f. The folding axis f may mean a virtual line extending through a hinge cover 251 in a direction (e.g., d1 of FIG. 2A and FIG. 2B) parallel to a longitudinal direction of the electronic device 200, but it is not limited thereto. For example, the folding axis f may be a virtual line extending in a direction (e.g., d2 of FIG. 2A and FIG. 2B) perpendicular to the longitudinal direction of the electronic device 200. In case that the folding axis f extends in the direction perpendicular to the longitudinal direction of the electronic device 200, the hinge structure 250 may connect the first housing 210 and the second housing 220 by extending in a direction parallel to the folding axis f. The first housing 210 and the second housing 220 may be rotatable by the hinge structure 250 extending in the direction perpendicular to the longitudinal direction of the electronic device 200.

According to an embodiment, the hinge structure 250 may include the hinge cover 251, a first hinge plate 252, a second hinge plate 253, and a hinge module 254. The hinge cover 251 may surround internal components of the hinge structure 250 and form an outer surface of the hinge structure 250. According to an embodiment, when the electronic device 200 is in the folded state, at least a portion of the hinge cover 251 surrounding the hinge structure 250 may be exposed to the outside of the electronic device 200 through a space between the first housing 210 and the second housing 220. According to another embodiment, when the electronic device 200 is in the unfolded state, the hinge cover 251 may not be exposed to the outside of the electronic device 200 by being covered by the first housing 210 and the second housing 220.

According to an embodiment, the first hinge plate 252 and the second hinge plate 253 may rotatably connect the first housing 210 and the second housing 220, by being respectively coupled to the first housing 210 and the second housing 220. For example, the first hinge plate 252 may be coupled with a first front bracket 215 of the first housing 210, and the second hinge plate 253 may be coupled with a second front bracket 227 of the second housing 220. As the first hinge plate 252 and the second hinge plate 253 are respectively coupled to the first front bracket 215 and the second front bracket 227, the first housing 210 and the second housing 220 may be rotatable according to rotation of the first hinge plate 252 and the second hinge plate 253.

The hinge module 254 may rotate the first hinge plate 252 and the second hinge plate 253. For example, the hinge module 254 may rotate the first hinge plate 252 and the second hinge plate 253 based on the folding axis f, including gears that may be rotatable by being engaged with each other. According to an embodiment, the hinge modules 254 may be plural. For example, a plurality of hinge modules 254 may be spaced apart from each other and disposed at both ends of the first hinge plate 252 and the second hinge plate 253, respectively.

According to an embodiment, the first housing 210 may include the first front bracket 215 and a rear bracket 216, and the second housing 220 may include the second front bracket 227. The first front bracket 215 and the rear bracket 216 may be disposed inside the first housing 210, and may support the components of the electronic device 200. The second front bracket 227 may be disposed inside the second housing 220, and may support the components of the electronic device 200. For example, the display 230 may be disposed on a surface of the first front bracket 215 and a surface of the second front bracket 227. The rear bracket 216 may be disposed on another surface of the first front bracket 215 facing the surface of the first front bracket 215. The sub-display panel 235 may be disposed on the rear bracket 216.

According to an embodiment, a portion of the first front bracket 215 may be surrounded by the first side surface 213, and a portion of the second front bracket 227 may be surrounded by the second side surface 223. For example, the first front bracket 215 may be integrally formed with the first side surface 213, and the second front bracket 227 may be integrally formed with the second side surface 223. For another example, the first front bracket 215 may be formed separately from the first side surface 213, and the second front bracket 227 may be formed separately from the second side surface 223.

The at least one electronic component 260 may implement various functions for providing to the user. According to an embodiment, the at least one electronic component 260 may include a first printed circuit board 261, a second printed circuit board 262, a flexible printed circuit board 263, a battery 264 (e.g., the battery 189 of FIG. 1), and/or an antenna 265 (e.g., the antenna module 197 of FIG. 1). The first printed circuit board 261 and the second printed circuit board 262 may respectively form an electrical connection between the components in the electronic device 200. For example, components (e.g., the processor 120 of FIG. 1) for implementing an overall function of the electronic device 200 may be disposed on the first printed circuit board 261, and electronic components for implementing a portion of functions of the first printed circuit board 261 may be disposed on the second printed circuit board 262. For another example, components for an operation of the sub-display panel 235 disposed on the fourth surface 222 may be disposed on the second printed circuit board 262.

According to an embodiment, the first printed circuit board 261 may be disposed in the first housing 210. For example, the first printed circuit board 261 may be disposed on a surface of the first front bracket 215. According to an embodiment, the second printed circuit board 262 may be disposed in the second housing 220. For example, the second printed circuit board 262 may be spaced apart from the first printed circuit board 261 and disposed on a surface of the second front bracket 227. The flexible printed circuit board 263 may connect the first printed circuit board 261 and the second printed circuit board 262. For example, the flexible printed circuit board 263 may extend from the first printed circuit board 261 to the second printed circuit board 262.

The battery 264, which is a device for supplying power to at least one component of the electronic device 200, may include, for example, a non-rechargeable primary battery, a rechargeable secondary battery, or a fuel cell. At least a portion of the battery 264 may be disposed on substantially the same plane as the first printed circuit board 261 or the second printed circuit board 262.

The antenna 265 may be configured to receive power or a signal from the outside of the electronic device 200. According to an embodiment, the antenna 265 may be disposed between the rear bracket 216 and the battery 264. The antenna 265 may include, for example, a near field communication (NFC) antenna, an antenna module, and/or a magnetic secure transmission (MST) antenna. The antenna 265 may perform, for example, short-range communication with an external device, or wirelessly transmit and receive the power required for charging.

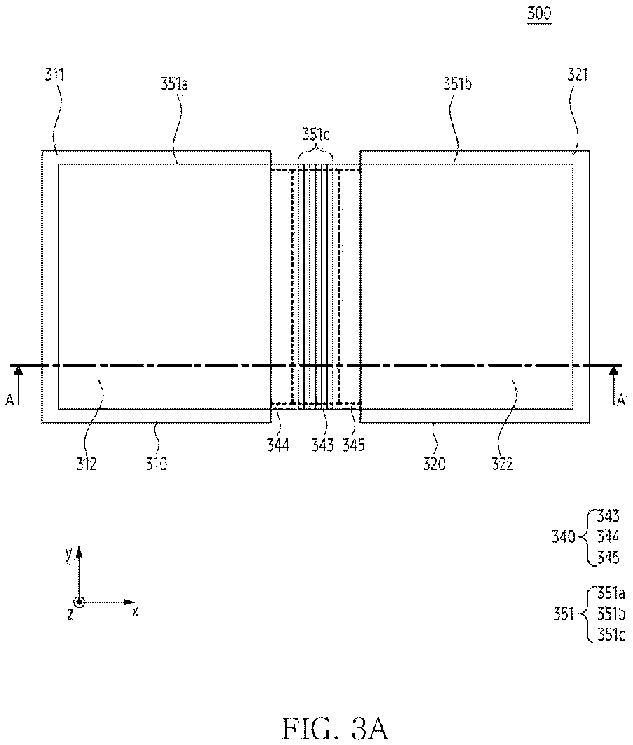

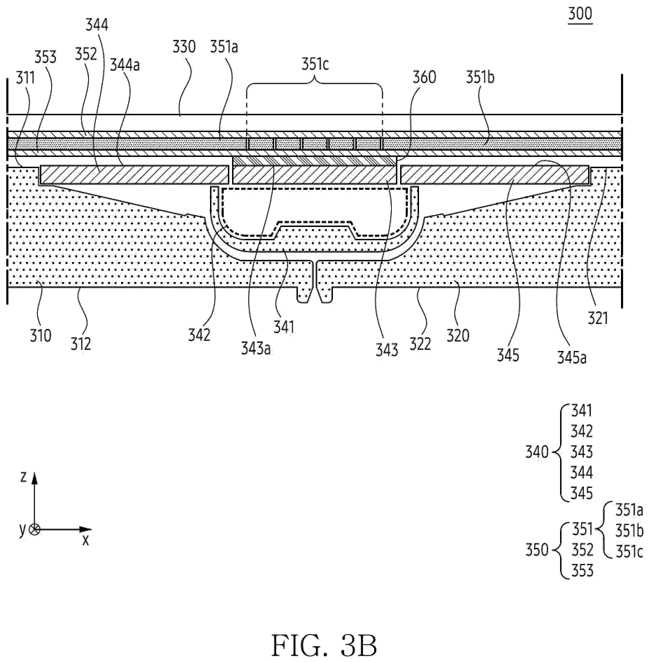

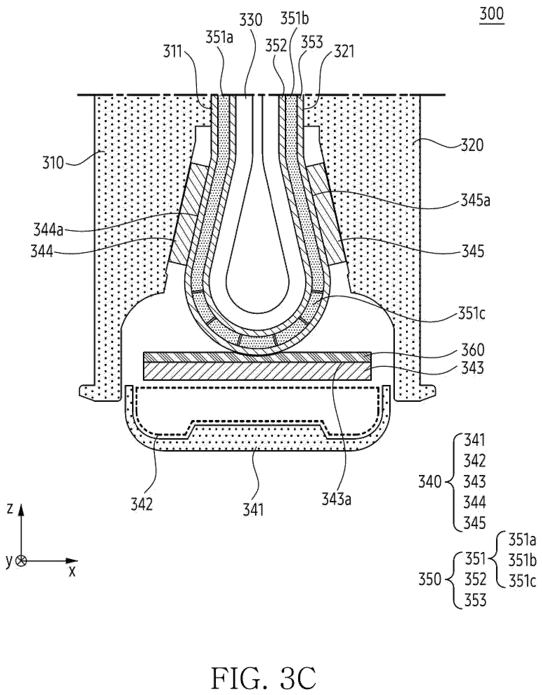

FIG. 3A is a top plan view of an exemplary electronic device according to an embodiment. FIG. 3B is a cross-sectional view illustrating an example of an exemplary electronic device in an unfolded state, cut along line A-A' of FIG. 3A. FIG. 3C is a cross-sectional view illustrating an example of an exemplary electronic device in a folded state, cut along line A-A' of FIG. 3A.

Referring to FIG. 3A, FIG. 3B, and FIG. 3C, an electronic device 300 (e.g., the electronic device 101 of FIG. 1 and/or the electronic device 200 of FIG. 2A, FIG. 2B, and FIG. 2C) according to an embodiment may include a first housing 310 (e.g., the first housing 210 of FIG. 2A, FIG. 2B, and FIG. 2C), a second housing 320 (e.g., the second housing 220 of FIG. 2A, FIG. 2B, and FIG. 2C), a display 330 (e.g., the display 230 of FIG. 2A, FIG. 2B, and FIG. 2C), a hinge structure 340 (e.g., the hinge structure 250 of FIG. 2A, FIG. 2B, and FIG. 2C), a layer 350, and/or a first conductive member 360.

According to an embodiment, the first housing 310 may support a portion of the display 330. The first housing 310 may be movable with respect to the second housing 320. For example, the first housing 310 may be rotatable with respect to the second housing 320. According to an embodiment, the first housing 310 may include a first surface 311 (e.g., the first surface 211 of FIG. 2A, FIG. 2B, and FIG. 2C), and a second surface 312 (e.g., the second surface 212 of FIG. 2A, FIG. 2B, and FIG. 2C). The first surface 311 may support the portion of the display 330. The first surface 311 may be an inner surface of the first housing 310 facing the portion of the display 330. The second surface 312 may be opposite to the first surface 311. For example, a direction in which the second surface 312 faces may be opposite to a direction in which the first surface 311 faces. The second surface 312 may mean an outer surface of the first housing 310 opposite to the first surface 311.

According to an embodiment, the second housing 320 may support another portion of the display 330. The second housing 320 may be movable with respect to the first housing 310. For example, the second housing 320 may be rotatable with respect to the first housing 310. According to an embodiment, the second housing 320 may include a third surface 321 (e.g., the third surface 321 of FIG. 2A, FIG. 2B, and FIG. 2C), and a fourth surface 322 (e.g., the fourth surface 222 of FIG. 2A, FIG. 2B, and FIG. 2C). The third surface 321 may support the other portion of the display 330. The third surface 321 may be an inner surface of the second housing 320 facing the other portion of the display 330. The fourth surface 322 may be opposite to the third surface 321. For example, a direction in which the fourth surface 322 faces may be opposite to a direction in which the third surface 321 faces. The fourth surface 322 may mean an outer surface of the second housing 320 opposite to the third surface 321.

According to an embodiment, the display 330 may be supported by the first housing 310 and the second housing 320. The display 330 may be disposed on the first housing 310 and the second housing 320 across the hinge structure 340. When an element is referred to as being "on" another element, it should be understood that it may be directly on the other element, or that there may be intervening elements therebetween. In contrast, when the element is referred to as being "directly on" the other element, there are no intervening elements. For example, the display 330 may be disposed on the first surface 311 of the first housing 310 and the third surface 321 of the second housing 320. According to an embodiment, the display 330 may be foldable by movement of the second housing 320 with respect to the first housing 310. For example, as a state of the electronic device 300 changes from the unfolded state in which a direction in which the first surface 311 faces is substantially the same as a direction in which the third surface 321 faces, to the folded state in which the first surface 331 and the third surface 321 face each other, the display 330 may be folded. In the folded state of the electronic device 300, at least a portion of the display 330 may have a curvature and be bent. For example, as the state of the electronic device 300 changes from the folded state to the unfolded state, the display 330 may be unfolded. In the unfolded state of the electronic device 300, the display 330 may be substantially parallel to the first surface 311 of the first housing 310 and the third surface 321 of the second housing 320.

According to an embodiment, the hinge structure 340 may rotatably couple the first housing 310 and the second housing 320. For example, the first housing 310 may be coupled to the second housing 320 through the hinge structure 340 so as to be rotatable with respect to the second housing 320. For example, the second housing 320 may be coupled to the first housing 310 through the hinge structure 340 so as to be rotatable with respect to the first housing 310. The hinge structure 340 may fold or unfold the display 330 based on receiving a driving force from the first housing 310 or the second housing 320. According to an embodiment, the hinge structure 340 may include a hinge cover 341, a hinge bracket 342, a first hinge plate 343, a second hinge plate 344, and/or a third hinge plate 345.

The hinge cover 341 may define an outer surface of the hinge structure 340. For example, the hinge cover 341 may surround the hinge bracket 342, the first hinge plate 343, and the second hinge plate 344. According to an embodiment, the hinge cover 341 may be covered by the first housing 310 and the second housing 320 in the unfolded state of the electronic device 300. The hinge cover 341 may be exposed to an outside of the electronic device 300 in the folded state of the electronic device 300. For example, the hinge cover 341 may be exposed to an outside of the first housing 310 and the second housing 320 in the folded state of the electronic device 300.

The hinge bracket 342 may support the first hinge plate 343, the second hinge plate 344, and the third hinge plate 345. According to an embodiment, the hinge bracket 342 may be coupled with the first hinge plate 343, the second hinge plate 344, and the third hinge plate 345. For example, the first hinge plate 343 may be fastened by being coupled to the hinge bracket 342. For example, the second hinge plate 344 may be coupled to the hinge bracket 342 so as to be rotatable with respect to the hinge bracket 342. For example, the third hinge plate 345 may be coupled to the hinge bracket 342 so as to be rotatable with respect to the hinge bracket 342. According to an embodiment, the hinge bracket 342 may provide a rotation axis of each of the second hinge plate 344 and the third hinge plate 345. For example, the hinge bracket 342 may include grooves accommodating each of the second hinge plate 344 and the third hinge plate 345. In case that the hinge bracket 342 includes the grooves, each of the second hinge plate 344 and the third hinge plate 345 may be rotatable along each of the grooves of the hinge bracket 342. According to an embodiment, the hinge bracket 342 may be disposed in the hinge cover 341. For example, the hinge bracket 342 may be surrounded by the hinge cover 341.

The first hinge plate 343 may support the display 330. For example, the first hinge plate 343 may be fastened to the hinge bracket 342 while the state of the electronic device 300 changes from the unfolded state to the folded state, or from the folded state to the unfolded state. According to an embodiment, a surface 343a of the first hinge plate 343 may face the display 330. For example, a direction (e.g., +z direction) in which the surface 343a of the first hinge plate 343 faces may be constant while the state of the electronic device 300 changes. According to an embodiment, the first hinge plate 343 may be disposed between the second hinge plate 344 and the third hinge plate 345. For example, the first hinge plate 343 may be disposed between a side surface of the second hinge plate 344 and a side surface of the third hinge plate 345 facing the side surface of the second hinge plate 344 in the unfolded state of the electronic device 300.

The second hinge plate 344 may be movable with respect to the first hinge plate 343. For example, the second hinge plate 344 may be rotatable with respect to the first hinge plate 343. According to an embodiment, a surface 344a of the second hinge plate 344 may face the display 330. As the surface 344a of the second hinge plate 344 faces the display 330, the display 330 may be foldable by movement of the second hinge plate 344 with respect to the first hinge plate 343.

The third hinge plate 345 may be movable with respect to the first hinge plate 343. For example, the third hinge plate 345 may be rotatable with respect to the first hinge plate 343. According to an embodiment, a surface 345a of the third hinge plate 345 may face the display 330. As the surface 345a of the third hinge plate 345 faces the display 330, the display 330 may be foldable by movement of the third hinge plate 345 with respect to the first hinge plate 343.

According to an embodiment, a rotation angle range of the second housing 320 rotatable with respect to the first housing 310 may be smaller than a rotation angle range of the second hinge plate 344 rotatable with respect to the first hinge plate 343. The rotation angle range of the second housing 320 rotatable with respect to the first housing 310 may be smaller than a rotation angle range of the third hinge plate 345 rotatable with respect to the first hinge plate 343. For example, a rotation angle range of the first housing 310 rotatable with respect to the second housing 320 may be smaller than a rotation angle range of each of the second hinge plate 344 and the third hinge plate 345 rotatable with respect to the first hinge plate 343. For example, while the state of the electronic device 300 changes from the unfolded state to the folded state, the first housing 310 and the second housing 320 may respectively rotate 90 degrees, and the second hinge plate 344 and the third hinge plate 345 may respectively rotate 100 degrees.

According to an embodiment, in the unfolded state of the electronic device 300, a direction (e.g., +z direction) in which the surface 344a of the second hinge plate 344 faces may be substantially the same as a direction (e.g., +z direction) in which the surface 345a of the third hinge plate 345 faces. In the unfolded state of the electronic device 300, the state of the electronic device 300 may change from the unfolded state to the folded state by movement of the second hinge plate 344 and the third hinge plate 345 with respect to the first hinge plate 343. According to an embodiment, in the folded state of the electronic device 300, the surface 344a of the second hinge plate 344 may be inclined with respect to the surface 345a of the third hinge plate 345. For example, in the folded state of the electronic device 300, the surface 344a of the second hinge plate 344 may be inclined with respect to the first surface 311 of the first housing 310. For example, in the folded state of the electronic device 300, the surface 345a of the third hinge plate 345 may be inclined with respect to the third surface 321 of the second housing 320. Since a rotation angle of the second hinge plate 344 and the third hinge plate 345 and the rotation angle range of the first housing 310 and the second housing 320 are different, the electronic device 300 according to an embodiment may provide a structure in which a change in curvature of a portion of the display 330 positioned between the second hinge plate 344 and the third hinge plate 345, is gradual. For example, in the folded state of the electronic device 300, in case that the second hinge plate 344 faces the third hinge plate 345, the curvature of the display 330 positioned between the second hinge plate 344 and the third hinge plate 345 may change rapidly between the second hinge plate 344 and the third hinge plate 345. Since the second hinge plate 344 and the third hinge plate 345 are inclined with respect to each other in the folded state of the electronic device 300, the electronic device 300 according to an embodiment may provide a structure in which the change in curvature of the display 330 is gradual. Since the curvature of the display 330 gradually changes, the electronic device 300 according to an embodiment may provide a structure for reducing formation of a wrinkle on the display 330.

The layer 350 may be attached to the display 330. According to an embodiment, the layer 350 may be disposed on the hinge structure 340. For example, the layer 350 may be disposed on the first surface 311 of the first housing 310 and the third surface 321 of the second housing 320, across the hinge structure 340. According to an embodiment, the layer 350 may have a shape corresponding to a shape of the display 330. For example, in the unfolded state of the electronic device 300, the layer 350 may have a shape parallel to the first hinge plate 343 together with the display 330. For example, in the folded state of the electronic device 300, as the display 330 is bent, the layer 350 may have a bent shape. According to an embodiment, in the unfolded state of the electronic device 300, the layer 350 may be spaced apart from the hinge structure 340. For example, in the unfolded state of the electronic device 300, the layer 350 may be spaced apart from the surface 344a of the second hinge plate 344 and the surface 345a of the third hinge plate 345. In the folded state of the electronic device 300, the layer 350 may be in contact with the surface 344a of the second hinge plate 344 and the surface 345a of the third hinge plate 345. According to an embodiment, the layer 350 may include a first heat dissipation member 351, a first deformation member 352, and a second deformation member 353.

The first heat dissipation member 351 may thermally connect the first housing 310 and the second housing 320. For example, the first heat dissipation member 351 may be manufactured with a material with high thermal conductivity. For example, the first heat dissipation member 351 may include graphite. According to an embodiment, the first heat dissipation member 351 may include a first segment 351a, a second segment 351b, and a plurality of third segments 351c.

The first segment 351a may be attached on the display 330. For example, a portion of the first segment 351a may be disposed on the first hinge plate 343. For example, another portion of the first segment 351a may be disposed on the second hinge plate 344. For example, the other portion of the first segment 351a may be disposed on the first surface 311 of the first housing 310.

The second segment 351b may be attached on the display 330. The second segment 351b may be spaced apart from the first segment 351a. For example, a portion of the second segment 351b may be disposed on the first hinge plate 343. For example, another portion of the second segment 351b may be disposed on the third hinge plate 345. For example, the other portion of the second segment 351b may be disposed on the third surface 321 of the second housing 320.

The plurality of third segments 351c may be disposed between the first segment 351a and the second segment 351b. According to an embodiment, the plurality of third segments 351c may be spaced apart from each other. For example, as the plurality of third segments 351c are spaced apart from each other, a gap may be disposed between the plurality of third segments 351c. According to an embodiment, the plurality of third segments 351c may have a shape separated from each other. For example, the plurality of third segments 351c may be separated from the first segment 351a and the second segment 351b. According to an embodiment, the plurality of third segments 351c may be disposed on the first hinge plate 343. For example, the plurality of third segments 351c may be disposed on the surface 343a of the first hinge plate 343. According to an embodiment, the plurality of third segments 351c may be disposed on an area of the display 330 in which the change in curvature of the display 330 is large while the state of the electronic device 300 is changed. For example, in case that the first heat dissipation member 351 is integrally formed, the first heat dissipation member 351 attached to the display 330 may be folded or unfolded according to a change in the state of the electronic device 300. As the first heat dissipation member 351 is folded or unfolded, stress generated inside the first heat dissipation member 351 may damage the first heat dissipation member 351. Since the first heat dissipation member 351 includes the segments 351a, 351b, and 351c that are separated from each other, the electronic device 300 according to an embodiment may provide a structure capable of reducing damage to the first heat dissipation member 351 due to stress generated by repetition of the change in the state of the electronic device 300..

The first deformation member 352 may connect the segments 351a, 351b, and 351c of the first heat dissipation member 351 that are separated from each other. For example, the first deformation member 352 may have flexibility. As the first deformation member 352 has the flexibility, the first deformation member 352 may have a shape corresponding to the shape of the display 330. For example, the first deformable member 352 may include thermoplastic polyurethane (TPU), but it is not limited thereto. According to an embodiment, the first deformation member 352 may be attached to the first heat dissipation member 351. For example, the first deformation member 351 may be interposed between the display 330 and the first heat dissipation member 351. For example, the first deformation member 352 may be in contact with a surface of the first heat dissipation member 351 facing the display 330. According to an embodiment, the first deformation member 352 may extend across the hinge structure 340. For example, the first deformation member 352 may extend from the first housing 310 to the second housing 320 across the hinge structure 340. As the first deformation member 352 crosses the hinge structure 340, the first segment 351a, the second segment 351b, and the plurality of third segments 351c of the first heat dissipation member 351 may be connected by the first deformation member 352. According to an embodiment, the first deformation member 352 may thermally connect the first housing 310 and the second housing 320. For example, the first deformation member 352 may transfer heat generated from a portion of the display 330 disposed on the first housing 310 to another portion of the display 330 disposed on the second housing 320. For example, the first deformation member 352 may transfer the heat generated from the other portion of the display 330 disposed on the second housing 320 to the portion of the display 330. For example, the first deformation member 352 may transfer the heat generated in the first housing 310 to the second housing 320. For example, the first deformation member 352 may transfer the heat generated in the second housing 320 to the first housing 310.

The second deformation member 353 may connect the segments 351a, 351b, and 351c of the first heat dissipation member 351 that are separated from each other. For example, the second deformation member 353 may have the flexibility. As the second deformation member 353 has the flexibility, the second deformation member 353 may have a shape corresponding to the shape of the display 330. For example, the second deformable member 353 may include the thermoplastic polyurethane (TPU), but it is not limited thereto. According to an embodiment, the second deformation member 353 may be attached to the first heat dissipation member 351. For example, the second deformation member 353 may be interposed between the first heat dissipation member 351 and the first conductive member 360. For example, the second deformation member 353 may be in contact with another surface of the first heat dissipation member 351 opposite to the surface of the first heat dissipation member 351 facing the display 330. According to an embodiment, the second deformation member 353 may extend across the hinge structure 340. For example, the second deformation member 353 may extend from the first housing 310 to the second housing 320 across the hinge structure 340. As the second deformation member 353 crosses the hinge structure 340, the first segment 351a, the second segment 351b, and the plurality of third segments 351c of the first heat dissipation member 351 may be connected by the second deformation member 353. According to an embodiment, the second deformation member 353 may thermally connect the first housing 310 and the second housing 320. For example, the second deformation member 353 may transfer the heat generated from the portion of the display 330 disposed on the first housing 310 to the other portion of the display 330 disposed on the second housing 320. For example, the second deformation member 353 may transfer the heat generated from the other portion of the display 330 disposed on the second housing 320 to the portion of the display 330. For example, the second deformation member 353 may transfer the heat generated in the first housing 310 to the second housing 320. For example, the second deformation member 353 may transfer the heat generated in the second housing 320 to the first housing 310.

According to an embodiment, a size of the gap between the plurality of third segments 351c may be changed according to deformation of the display 330. For example, as the display 330 is folded or unfolded by the second hinge plate 344 and the third hinge plate 345, the gap between the plurality of third segments 351c may be changed. For example, as the state of electronic device 300 changes from the unfolded state to the folded state, the size of the gap between the plurality of third segments 351c may be reduced. For example, as the state of electronic device 300 changes from the folded state to the unfolded state, the size of the gap between the plurality of third segments 351c may be expanded.

The first conductive member 360 may thermally connect the first housing 310 and the second housing 320. For example, the first conductive member 360 may be manufactured with a material with the high thermal conductivity. For example, the first conductive member 360 may include a thermal interface material (TIM). The thermal interface material may include, for example, at least one of a nano TIM, a silicon TIM, an acrylic TIM, and a carbon fiber-based TIM, but it is not limited thereto. According to an embodiment, the first conductive member 360 may face the first heat dissipation member 351 in the layer 350. For example, the first conductive member 360 may be in contact with the second deformation member 353 attached to the first heat dissipation member 351. According to an embodiment, the first conductive member 360 may be attached on the first hinge plate 343. For example, the first conductive member 360 may be disposed on the surface 343a of the first hinge plate 343 facing the plurality of third segments 351c. For example, the first conductive member 360 may be attached on the surface 343a of the first hinge plate 343. According to an embodiment, the first conductive member 360 may be disposed between the second hinge plate 344 and the third hinge plate 345. For example, while the state of the electronic device 300 changes from the folded state to the unfolded state, the first conductive member 360 may be fastened on the first hinge plate 343. For example, while the state of the electronic device 300 changes from the unfolded state to the folded state, the first conductive member 360 may be fastened on the first hinge plate 343.

According to an embodiment, the first conductive member 360 may overlap a portion of the first segment 351a and a portion of the second segment 351b when the display 330 is viewed from above (e.g., z direction), in the unfolded state of the electronic device 300. For example, the first conductive member 360 may overlap the portion of the first segment 351a and the portion of the second segment 351b when the display 330 is viewed in a second direction (e.g., -z direction) opposite to a first direction (e.g., +z direction) in which the surface 343a of the first hinge plate 343 faces, in the unfolded state of the electronic device 300. According to an embodiment, a width of the first conductive member 360 may be greater than a width of the plurality of third segments 351c. For example, the width of the first conductive member 360 may be greater than a sum of the width of each of the plurality of third segments 351c. As the width of the first conductive member 360 is greater than the width of the plurality of third segments 351c, the first conductive member 360 may overlap the first segment 351a and the second segment 351b. For example, heat generated from the first housing 310 or the display 330 may move toward the second housing 320 along the first segment 351a of the layer 350. Since the first segment 351a and the plurality of third segments 351c are separated from each other, heat of the first segment 351a may not move to the second housing 320 through the plurality of third segments 351c. As heat in the first housing 310 does not move to the second housing 320, the heat generated in the first housing 310 or the display 330 may be concentrated in the first housing 310. When the heat is concentrated in the first housing 310, performance of electronic components in the first housing 310 may deteriorate. In case that the first heat dissipation member 351 is integrally formed for heat transfer between the first housing 310 and the second housing 320, the first heat dissipation member 351 may be damaged by folding the display 330. The electronic device 300 according to an embodiment may provide a structure capable of dissipating heat in the electronic device 300 by the first conductive member 360 overlapping the portion of the first segment 351a and the portion of the second segment 351b. For example, in the unfolded state of the electronic device 300, the heat transferred from the first housing 310 to the portion of the first segment 351a may be transferred to the first conductive member 360 as the heat passes through the second deformation member 353. The heat transferred to the first conductive member 360 may be transferred to the portion of the second segment 351b overlapping the first conductive member 360 as the heat passes through the second deformation member 353. As the heat transferred to the portion of the second segment 351b is transferred to the second housing 320, the heat in the electronic device 300 may be dissipated.

According to an embodiment, the first conductive member 360 may be deformable. For example, when the display 330 is deformed, the first conductive member 360 may be deformable by the layer 350 attached to the display 330. For example, as the state of the electronic device 300 is deformed from the unfolded state to the folded state, the display 330 may be folded. As the display 330 is folded, the layer 350 attached to the display 330 may be folded. A reaction force generated by folding of the display 330 and the layer 350 may press the first conductive member 360 disposed on the first hinge plate 343 in a direction (e.g., -z direction) facing the hinge bracket 342. In case that the first conductive member 360 is not deformable, the first conductive member 360 may be damaged by pressure of the display 330 and the layer 350. In case that the first conductive member 360 is not deformable, the display 330 and the layer 350 may be damaged by the first conductive member 360 in contact with the display 330 and the layer 350. The electronic device 300 according to an embodiment may provide a structure capable of reducing damage to the display 330 and/or the first conductive member 360 due to repetition of the change in the state of the electronic device 300, by the deformable first conductive member 360. For example, the first conductive member 360 may be compressed as the state of the electronic device 300 changes from the unfolded state to the folded state. As the state of the electronic device 300 changes from the folded state to the unfolded state, a shape of the first conductive member 360 may be restored.

As described above, the electronic device 300 according to an embodiment may provide a structure capable of thermally connecting the first housing 310 and the second housing 320 despite the repetition of the change in the state of the electronic device 300, by the first heat dissipation member 351 including the plurality of segments 351a, 351b, and 351c that are separated from each other. The electronic device 300 according to an embodiment may provide a structure capable of dissipating the heat generated in the first housing 310 to the second housing 320 by the first conductive member 360 overlapping the first segment 351a and the second segment 351b in the unfolded state of the electronic device 300.

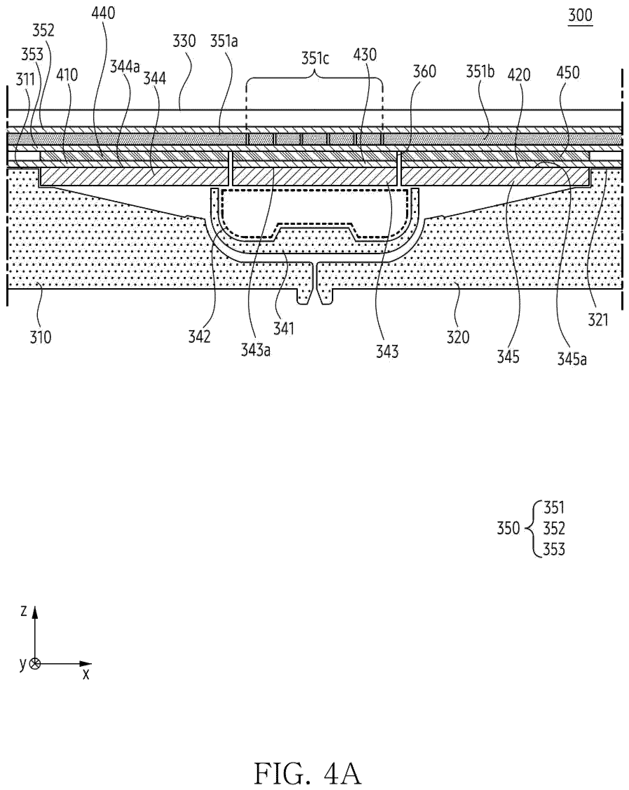

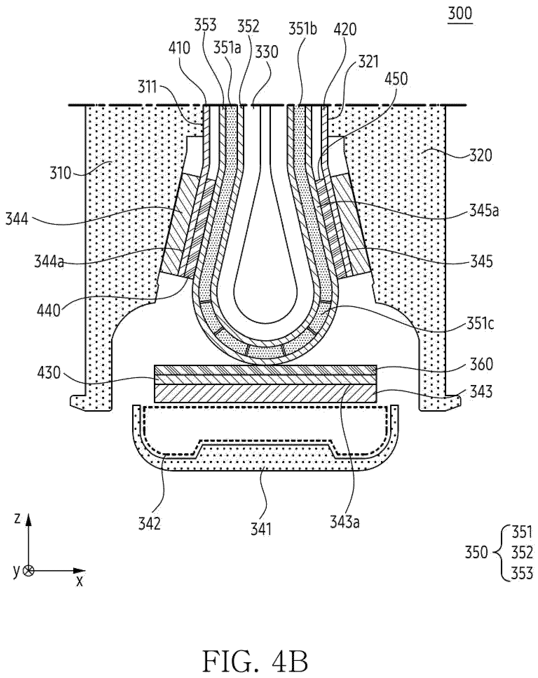

FIG. 4A is a cross-sectional view illustrating an example of cutting an exemplary electronic device in an unfolded state, and FIG. 4B is a cross-sectional view illustrating an example of cutting an exemplary electronic device in a folded state.

Since an electronic device 300 of FIG. 4A and FIG. 4B may be the electronic device 300 to which a second heat dissipation member 410, a third heat dissipation member 420, a fourth heat dissipation member 430, a second conductive member 440, and/or a third conductive member 450 are added to the electronic device 300 of FIG. 3A, FIG. 3B, and FIG. 3C, a redundant description will be omitted.

Referring to FIG. 4A and FIG. 4B, the electronic device 300 according to an embodiment may include the second heat dissipation member 410, the third heat dissipation member 420, the fourth heat dissipation member 430, the second conductive member 440, and/or the third conductive member 450.

The second heat dissipation member 410 may transfer heat transferred from a first housing 310 to the second conductive member 440. For example, the second heat dissipation member 410 may be manufactured with a material with high thermal conductivity. For example, the second heat dissipation member 410 may include graphite. According to an embodiment, the second heat dissipation member 410 may extend in a direction from the first housing 310 toward a second housing 320. For example, the second heat dissipation member 410 may extend on a first surface 311 of the first housing 310. For example, the second heat dissipation member 410 may extend from the first housing 310 to a surface 344a of a second hinge plate 344. According to an embodiment, the second heat dissipation member 410 may be disposed on the second hinge plate 344. For example, the second heat dissipation member 410 may be disposed on the surface 344a of the second hinge plate 344. According to an embodiment, the second heat dissipation member 410 may be spaced apart from a layer 350. For example, the layer 350 may be spaced apart from the second heat dissipation member 410 in a direction in which the surface 344a of the second hinge plate 344 faces. As the second heat dissipation member 410 extends from the first housing 310 to the second hinge plate 344, a path through which the heat transferred in the first housing 310 can move may expand.

The third heat dissipation member 420 may transfer the heat transferred from the second housing 320 to the third conductive member 450. For example, the third heat dissipation member 420 may be manufactured with a material with the high thermal conductivity. For example, the third heat dissipation member 420 may include the graphite. According to an embodiment, the third heat dissipation member 420 may extend in a direction from the second housing 320 toward the first housing 310. For example, the third heat dissipation member 420 may extend on a third surface 321 of the second housing 320. For example, the third heat dissipation member 420 may extend from the second housing 320 to a surface 345a of a third hinge plate 345. According to an embodiment, the third heat dissipation member 420 may be disposed on the third hinge plate 345. For example, the third heat dissipation member 420 may be disposed on the surface 345a of the third hinge plate 345. According to an embodiment, the third heat dissipation member 420 may be spaced apart from the layer 350. For example, the layer 350 may be spaced apart from the third heat dissipation member 420 in a direction in which the surface 345a of the third hinge plate 345 faces. As the third heat dissipation member 420 extends from the second housing 320 to the third hinge plate 344, a path through which the heat transferred in the second housing 320 can move may expand.

The fourth heat dissipation member 430 may transfer heat transferred from a first segment 351a to a second segment 351b. According to an embodiment, the fourth heat dissipation member 430 may be disposed on a first hinge plate 343. For example, the fourth heat dissipation member 430 may be interposed between a first conductive member 360 and a surface 343a of the first hinge plate 343. According to an embodiment, the fourth heat dissipation member 430 may face a plurality of third segments 351c. The fourth heat dissipation member 430 may overlap a portion of the first segment 351a and a portion of the second segment 351b when a display 330 is viewed from above (e.g., z direction) in the unfolded state of the electronic device 300. The fourth heat dissipation member 430 may overlap the portion of the first segment 351a and the portion of the second segment 351b when the display 330 is viewed in a second direction (e.g., -z direction) opposite to a first direction (e.g., +z direction) in which the surface 343a of the first hinge plate 343 faces, in the unfolded state of the electronic device 300. As the fourth heat dissipation member 430 is disposed on the first hinge plate 343, a path through which the heat can move between the first segment 351a and the second segment 351b may expand.

According to an embodiment, the fourth heat dissipation member 430 may be separated from the second heat dissipation member 410 and the third heat dissipation member 420. For example, the fourth heat dissipation member 430 may be spaced apart from the second heat dissipation member 410 and the third heat dissipation member 420. As the second heat dissipation member 410 and the third heat dissipation member 420 are separated from each other, damage to the heat dissipation members 410, 420, and 430 due to repetition of a change in a state of the electronic device 300 may be reduced.

The second conductive member 440 may thermally connect the layer 350 and the second heat dissipation member 410. For example, the second conductive member 440 may be manufactured with a material with the high thermal conductivity. For example, the second conductive member 440 may include a thermal interface material (TIM). The thermal interface material may include, for example, at least one of a nano TIM, a silicon TIM, an acrylic TIM, and a carbon fiber-based TIM, but it is not limited thereto. According to an embodiment, the second conductive member 440 may be interposed between the layer 350 and the second heat dissipation member 410. For example, the second conductive member 440 may be attached to the second heat dissipation member 410 attached to the second hinge plate 344. For example, the second conductive member 440 may be disposed on the second heat dissipation member 410, and face the first segment 351a of the layer 350. According to an embodiment, the second conductive member 440 may be deformable.

The third conductive member 450 may thermally connect the layer 350 and the third heat dissipation member 420. For example, the third conductive member 450 may be manufactured with a material with the high thermal conductivity. For example, the third conductive member 450 may include the thermal interface material (TIM). The thermal interface material may include, for example, at least one of the nano TIM, the silicon TIM, the acrylic TIM, and the carbon fiber-based TIM, but it is not limited thereto. According to an embodiment, the third conductive member 450 may be interposed between the layer 350 and the third heat dissipation member 420. For example, the third conductive member 450 may be attached to the third heat dissipation member 420 attached to the third hinge plate 345. For example, the third conductive member 450 may be disposed on the third heat dissipation member 420, and face the second segment 351b of the layer 350. According to an embodiment, the third conductive member 450 may be deformable.

According to an embodiment, the heat generated in the first housing 310 may be transferred to the second heat dissipation member 410. The heat transferred to the second heat dissipation member 410 may be transferred to the first segment 351a by passing through the second conductive member 440 and the second deformation member 353. The heat transferred to the first segment 351a may be transferred to the first conductive member 360 and the fourth heat dissipation member 430 by passing through the second deformation member 353. The heat transferred to the first conductive member 360 and the fourth heat dissipation member 430 may be transferred to the second segment 351b by passing through the second deformation member 353. As the heat transferred to the second segment 351b is transferred to the third conductive member 450 and the third heat dissipation member 420 by passing through the second deformation member 353, the heat generated in the first housing 310 may be dissipated to the second housing 320. According to an embodiment, the heat generated in the second housing 320 may be transferred to the third heat dissipation member 420. The heat transferred to the third heat dissipation member 420 may be transferred to the second segment 351b by passing through the third conductive member 450 and the second deformation member 353. The heat transferred to the second segment 351b may be transferred to the first conductive member 360 and the fourth heat dissipation member 430 by passing through the second deformation member 353. The heat transferred to the first conductive member 360 and the fourth heat dissipation member 430 may be transferred to the first segment 351a by passing through the second deformation member 353. As the heat transferred to the first segment 351a is transferred to the second conductive member 440 and the second heat dissipation member 410 by passing through the second deformation member 353, the heat generated in the second housing 320 may be dissipated in the first housing 310.

According to an embodiment, the second heat dissipation member 410 and the second conductive member 440 may be parallel to the display 330 in the unfolded state of the electronic device 300. When the second hinge plate 344 moves to change the state of the electronic device 300 from the unfolded state to the folded state, the second heat dissipation member 410 and the second conductive member 440 may move together with the second hinge plate 344. In the folded state of the electronic device 300, a portion of the second heat dissipation member 410 attached on the surface 344a of the second hinge plate 344 may be inclined with respect to another portion of the second heat dissipation member 410 attached on the first surface 311 of the first housing 310.

According to an embodiment, in the unfolded state of the electronic device 300, the third heat dissipation member 420 and the third conductive member 450 may be parallel to the display 330. When the third hinge plate 345 moves to change the state of the electronic device 300 from the unfolded state to the folded state, the third heat dissipation member 420 and the third conductive member 450 may move together with the third hinge plate 345. In the folded state of the electronic device 300, a portion of the third heat dissipation member 420 attached on the surface 345a of the third hinge plate 345 may be inclined with respect to another portion of the third heat dissipation member 420 attached on the third surface 321 of the second housing 320.

According to an embodiment, as the fourth heat dissipation member 430 is attached on the first hinge plate 343, the fourth heat dissipation member 430 may be fastened while the state of the electronic device 300 changes. For example, the fourth heat dissipation member 430 may be fastened on the first hinge plate 343 when the second hinge plate 344 and the third hinge plate 345 move.

As described above, the electronic device 300 according to an embodiment may reduce the concentration of heat in the electronic device 300, by the heat dissipation members 410, 420, and 430 and the conductive members 440 and 450 for dissipating the heat generated in the housings 310 and 320.

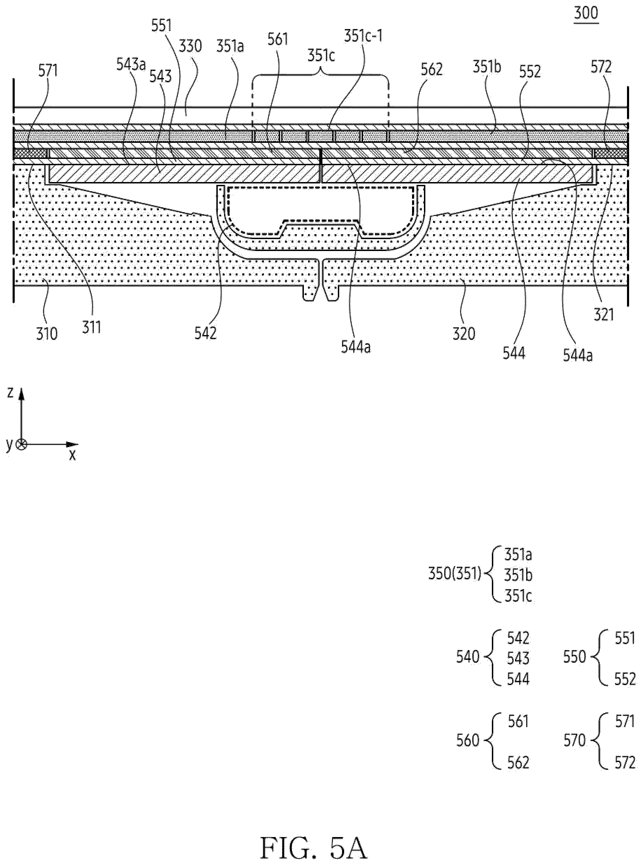

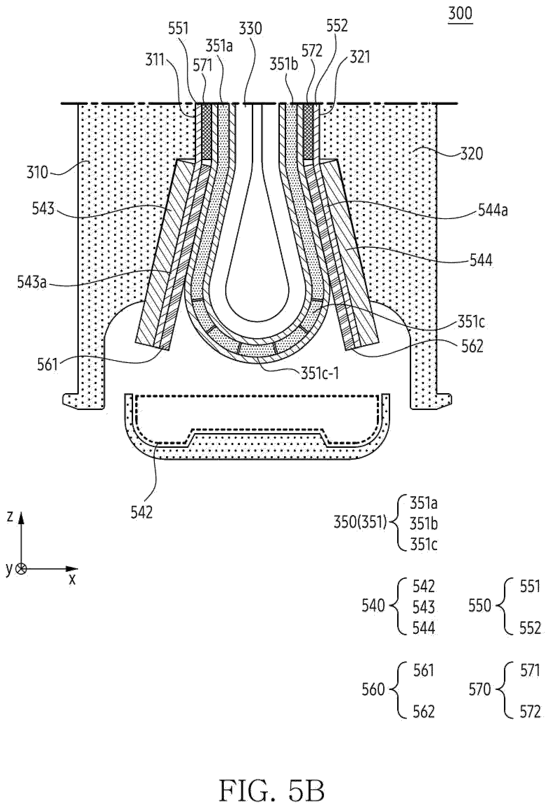

FIG. 5A is a cross-sectional view illustrating an example of cutting an exemplary electronic device in an unfolded state, and FIG. 5B is a cross-sectional view illustrating an example of cutting an exemplary electronic device in a folded state.

Since an electronic device 300 of FIG. 5A and FIG. 5B may be the electronic device 300 in which a structure of the hinge structure 340 is changed in the electronic device 300 of FIG. 3A, FIG. 3B, and FIG. 3C, a redundant description will be omitted.

Referring to FIG. 5A and FIG. 5B, the electronic device 300 according to an embodiment may include a hinge structure 540 (e.g., the hinge structure 340 of FIG. 3A, FIG. 3B, and FIG. 3C), a plurality of heat dissipation members 550, a plurality of conductive members 560, and/or a plurality of reinforcement members 570.

According to an embodiment, the hinge structure 540 may rotatably couple a first housing 310 and a second housing 320. For example, the second housing 320 may be coupled to the first housing 310 through the hinge structure 540 so as to be rotatable with respect to the first housing 310. According to an embodiment, the hinge structure 540 may include a hinge bracket 542, a fourth hinge plate 543, and/or a fifth hinge plate 544.

The hinge bracket 542 may support the fourth hinge plate 543 and the fifth hinge plate 544. According to an embodiment, the hinge bracket 542 may be coupled with the fourth hinge plate 543 and the fifth hinge plate 544. For example, the fourth hinge plate 543 may be coupled to the hinge bracket 542 so as to be rotatable with respect to the hinge bracket 542. For example, the fifth hinge plate 544 may be coupled to the hinge bracket 542 so as to be rotatable with respect to the hinge bracket 542. According to an embodiment, the hinge bracket 542 may provide a rotation axis of each of the fourth hinge plate 543 and the fifth hinge plate 544. For example, the hinge bracket 542 may include a groove accommodating each of the fourth hinge plate 543 and the fifth hinge plate 544. In case that the hinge bracket 542 includes grooves, each of the fourth hinge plate 543 and the fifth hinge plate 544 may be rotatable along each of the grooves of the hinge bracket 542.

The fourth hinge plate 543 may be movable with respect to the hinge bracket 542. According to an embodiment, a surface 543a of the fourth hinge plate 543 may face a display 330. As the surface 543a of the fourth hinge plate 543 faces the display 330, the display 330 may be foldable by movement of the fourth hinge plate 543 with respect to the hinge bracket 542.

The fifth hinge plate 544 may be movable with respect to the hinge bracket 542. According to an embodiment, a surface 544a of the fifth hinge plate 544 may face the display 330. As the surface 544a of the fifth hinge plate 544 faces the display 330, the display 330 may be foldable by movement of the fifth hinge plate 544 with respect to the hinge bracket 542.

According to an embodiment, a rotation angle range of the second housing 320 rotatable with respect to the first housing 310 may be smaller than a rotation angle range of the fourth hinge plate 543 rotatable with respect to the hinge bracket 542. The rotation angle range of the second housing 320 rotatable with respect to the first housing 310 may be smaller than a rotation angle range of the fifth hinge plate 544 rotatable with respect to the hinge bracket 542. For example, a rotation angle range of the first housing 310 rotatable with respect to the second housing 320 may be smaller than a rotation angle range of each of the fourth hinge plate 543 and the fifth hinge plate 544 rotatable with respect to the hinge bracket 542. For example, while a state of the electronic device 300 changes from the unfolded state to the folded state, the first housing 310 and the second housing 320 may respectively rotate 90 degrees, and the fourth hinge plate 543 and the fifth hinge plate 544 may respectively rotate 100 degrees.

According to an embodiment, in the unfolded state of the electronic device 300, a direction (e.g., +z direction) in which the surface 543a of the fourth hinge plate 543 faces may be substantially the same as a direction (e.g., +z direction) in which the surface 544a of the fifth hinge plate 544 faces. In the unfolded state of the electronic device 300, the state of the electronic device 300 may change from the unfolded state to the folded state, by movement of the fourth hinge plate 543 and the fifth hinge plate 544 with respect to the hinge bracket 542. According to an embodiment, in the folded state of the electronic device 300, the surface 543a of the fourth hinge plate 543 may be inclined with respect to the surface 544a of the fifth hinge plate 544. For example, in the folded state of the electronic device 300, the surface 543a of the fourth hinge plate 543 may be inclined with respect to a first surface 311 of the first housing 310. For example, in the folded state of the electronic device 300, the surface 544a of the fifth hinge plate 544 may be inclined with respect to a third surface 321 of the second housing 320.

The plurality of heat dissipation members 550 may transfer heat generated in the first housing 310 to the second housing 320, or transfer heat generated in the second housing 320 to the first housing 310. For example, the plurality of heat dissipation members 550 may be manufactured with a material with high thermal conductivity. For example, the plurality of heat dissipation members 550 may include graphite. According to an embodiment, the plurality of heat dissipation members 550 may include a fifth heat dissipation member 551 and a sixth heat dissipation member 552.

The fifth heat dissipation member 551 may transfer the heat transferred from the first housing 310 to the plurality of conductive members 560. According to an embodiment, the fifth heat dissipation member 551 may extend in a direction from the first housing 310 toward the second housing 320. For example, the fifth heat dissipation member 551 may extend on the first surface 311 of the first housing 310. For example, the fifth heat dissipation member 551 may extend from the first housing 310 to the surface 543a of the fourth hinge plate 543. According to an embodiment, the fifth heat dissipation member 551 may be disposed on the fourth hinge plate 543. For example, the fifth heat dissipation member 551 may be disposed on the surface 543a of the fourth hinge plate 543. According to an embodiment, the fifth heat dissipation member 551 may be spaced apart from a layer 350. For example, the layer 350 may be spaced apart from the fifth heat dissipation member 551 in a direction in which the surface 543a of the fourth hinge plate 543 faces. As the fifth heat dissipation member 551 extends from the first housing 310 to the fourth hinge plate 543, a path through which the heat transferred in the first housing 310 can move may expand.

The sixth heat dissipation member 552 may transfer the heat transferred from the second housing 320 to the plurality of conductive members 560. According to an embodiment, the sixth heat dissipation member 552 may extend in a direction from the second housing 320 toward the first housing 310. For example, the sixth heat dissipation member 552 may extend on the third surface 321 of the second housing 320. For example, the sixth heat dissipation member 552 may extend from the second housing 320 to the surface 544a of the fifth hinge plate 544. According to an embodiment, the sixth heat dissipation member 552 may be disposed on the fifth hinge plate 544. For example, the sixth heat dissipation member 552 may be disposed on the surface 544a of the fifth hinge plate 544. According to an embodiment, the sixth heat dissipation member 552 may be spaced apart from the layer 350. For example, the layer 350 may be spaced apart from the sixth heat dissipation member 552 in a direction in which the surface 544a of the fifth hinge plate 544 faces. As the sixth heat dissipation member 552 extends from the second housing 320 to the fifth hinge plate 544, a path through which the heat transferred in the second housing 320 can move may expand. According to an embodiment, the sixth heat dissipation member 552 may be spaced apart from the fifth heat dissipation member 551.

The plurality of conductive members 560 may thermally connect the first housing 310 and the second housing 320. For example, the plurality of conductive members 560 may be thermally connected to a first segment 351a and a second segment 351b. For example, the plurality of conductive members 560 may be manufactured with a material with the high thermal conductivity. For example, the plurality of conductive members 560 may include a thermal interface material (TIM). The thermal interface material may include, for example, at least one of a nano TIM, a silicon TIM, an acrylic TIM, and a carbon fiber-based TIM, but it is not limited thereto. According to an embodiment, the plurality of conductive members 560 may include a fourth conductive member 561 and a fifth conductive member 562.

The fourth conductive member 561 may face the layer 350. For example, the fourth conductive member 561 may be attached on the surface 543a of the fourth hinge plate 543 facing the layer 350. According to an embodiment, the fourth conductive member 561 may face the first segment 351a and a plurality of third segments 351c. For example, the fourth conductive member 561 may face the first segment 351a and the plurality of third segments 351c between the layer 350 and the fifth heat dissipation member 551. According to an embodiment, the fourth conductive member 561 may be deformable. According to an embodiment, the fourth conductive member 561 may be spaced apart from the fourth hinge plate 543. For example, the fourth conductive member 561 may be spaced apart from the surface 543a of the fourth hinge plate 543 along the direction in which the surface 543a of the fourth hinge plate 543 faces. As the fourth hinge plate 543 and the fourth conductive member 561 are spaced apart from each other, the fifth heat dissipation member 551 may be disposed between the fourth conductive member 561 and the fourth hinge plate 543.

The fifth conductive member 562 may face the layer 350. For example, the fifth conductive member 562 may be attached on the surface 544a of the fifth hinge plate 544 facing the layer 350. According to an embodiment, the fifth conductive member 562 may face the second segment 351b and the plurality of third segments 351c. For example, the fifth conductive member 562 may face the second segment 351b and the plurality of third segments 351c between the layer 350 and the sixth heat dissipation member 552. According to an embodiment, the fifth conductive member 562 may be deformable. According to an embodiment, the fifth conductive member 562 may be spaced apart from the fifth hinge plate 544. For example, the fifth conductive member 562 may be spaced apart from the surface 544a of the fifth hinge plate 544 along the direction in which the surface 544a of the fifth hinge plate 544 faces. As the fifth hinge plate 544 and the fifth conductive member 562 are spaced apart from each other, the sixth heat dissipation member 552 may be disposed between the fifth conductive member 562 and the fifth hinge plate 544. According to an embodiment, the fifth conductive member 562 may be spaced apart from the fourth conductive member 561.

The plurality of reinforcement members 570 may support the display 330. For example, the plurality of reinforcement members 570 may be manufactured with a material with rigidity (e.g., metal). For example, the plurality of reinforcement members 570 may be referred to as a stiffener. According to an embodiment, the plurality of reinforcement members 570 may include a first reinforcement member 571 and a second reinforcement member 572.

The first reinforcement member 571 may be disposed between the first housing 310 and the display 330. For example, the first reinforcement member 571 may be disposed between the first surface 311 of the first housing 310 and the layer 350. As the first reinforcement member 571 is disposed on the first surface 311 of the first housing 310, the first reinforcement member 571 may face the first segment 351a. According to an embodiment, the first reinforcement member 571 may be disposed on a portion of the fifth heat dissipation member 551 disposed on the first surface 311. For example, the first reinforcement member 571 may be disposed between the fifth heat dissipation member 551 and the layer 350.

The second reinforcement member 572 may be disposed between the second housing 320 and the display 330. For example, the second reinforcement member 572 may be disposed between the third surface 321 of the second housing 320 and the layer 350. As the second reinforcement member 572 is disposed on the third surface 321 of the second housing 320, the second reinforcement member 572 may face the second segment 351b. According to an embodiment, the second reinforcement member 572 may be disposed on a portion of the sixth heat dissipation member 552 disposed on the third surface 321. For example, the second reinforcement member 572 may be disposed between the sixth heat dissipation member 552 and the layer 350.

According to an embodiment, the layer 350 may extend from the first housing 310 to the second housing 320 across the hinge structure 540. For example, the layer 350 may be disposed on the fourth hinge plate 543 and the fifth hinge plate 544. According to an embodiment, the first segment 351a of the layer 350 may be disposed on a portion of the fourth hinge plate 543. For example, the first segment 351a may extend on the first surface 311 of the first housing 310. The first segment 351a may extend from the first housing 310 to the fourth hinge plate 543. According to an embodiment, the first segment 351a may be disposed on a portion of the fourth conductive member 561. According to an embodiment, the second segment 351b of the layer 350 may be disposed on the fifth hinge plate 544. For example, the second segment 351b may extend on the third surface 321 of the second housing 320. The second segment 351b may extend from the second housing 320 to the fifth hinge plate 544. According to an embodiment, the second segment 351b may be disposed on a portion of the fifth conductive member 562. According to an embodiment, the plurality of third segments 351c may be disposed on the fourth hinge plate 543 and the fifth hinge plate 544. For example, the plurality of third segments 351c may face the fourth conductive member 561 disposed on the fourth hinge plate 543, and the fifth conductive member 562 disposed on the fifth hinge plate 544.

According to an embodiment, some 351c-1 of the plurality of third segments 351c may thermally connect the fourth conductive member 561 and the fifth conductive member 562. For example, the some 351c-1 of the plurality of third segments 351c may overlap the fourth conductive member 561 and the fifth conductive member 562 when the display 330 is viewed from above (e.g., z direction) in the unfolded state of the electronic device 300. For example, the some 351c-1 of the plurality of third segments 351c may overlap the fourth conductive member 561 and the fifth conductive member 562 when the display 330 is viewed in a second direction (e.g., -z direction) opposite to a first direction (e.g., +z direction) in which the surface 543a of the fourth hinge plate 543 faces in the unfolded state of the electronic device 300. According to an embodiment, a width of the some 351c-1 of the plurality of third segments 351c may be greater than a size of a gap between the fourth conductive member 561 and the fifth conductive member 562 in the unfolded state of the electronic device 300. For example, the heat generated in the display 330 may move along the first segment 351a, and the heat generated in the first housing 310 may move along the fifth heat dissipation member 551. The heat moving along each of the first segment 351a and the fifth heat dissipation member 551 may be transferred to the fourth conductive member 561. In case that the some 351c-1 of the plurality of third segments 351c do not overlap the fourth conductive member 561 and the fifth conductive member 562, the heat transferred to the fourth conductive member 561 may not be transferred to the second housing 320 because the plurality of third segments 351c are spaced apart from each other. In case that the heat generated in the first housing 310 is not transferred to the second housing 320, performance of electronic components disposed in the first housing 310 may deteriorate. The electronic device 300 according to an embodiment may provide a structure capable of dissipating the heat in the electronic device 300, by the some 351c-1 of the plurality of third segments 351c overlapping the fourth conductive member 561 and the fifth conductive member 562. For example, the heat transferred to the fourth conductive member 561 may be transferred to the fifth conductive member 562 through the some 351c-1 of the plurality of third segments 351c. As the heat transferred to the fifth conductive member 562 is respectively transferred to the second segment 351b and/or the sixth heat dissipation member 552, the heat generated in the electronic device 300 may be dissipated.

According to an embodiment, in the unfolded state of the electronic device 300, the fifth heat dissipation member 551 and the fourth conductive member 561 may be parallel to the display 330. When the fourth hinge plate 543 moves to change the state of the electronic device 300 from the unfolded state to the folded state, the fifth heat dissipation member 551 and the fourth conductive member 561 may move together with the fourth hinge plate 543. In the folded state of the electronic device 300, a portion of the fifth heat dissipation member 551 attached on the surface 543a of the fourth hinge plate 543 may be inclined with respect to another portion of the fifth heat dissipation member 551 attached on the first surface 311 of the first housing 310.

According to an embodiment, in the unfolded state of the electronic device 300, the sixth heat dissipation member 552 and the fifth conductive member 562 may be parallel to the display 330. When the fifth hinge plate 544 moves to change the state of the electronic device 300 from the unfolded state to the folded state, the sixth heat dissipation member 552 and the fifth conductive member 562 may move together with the fifth hinge plate 544. In the folded state of the electronic device 300, a portion of the sixth heat dissipation member 552 attached on the surface 544a of the fifth hinge plate 544 may be inclined with respect to another portion of the sixth heat dissipation member 552 attached on the third surface 321 of the second housing 320.

As described above, the electronic device 300 according to an embodiment may provide a structure capable of dissipating the heat generated in the electronic device 300 by the some 351c-1 of the plurality of third segments 351c thermally connecting the fourth conductive member 561 and the fifth conductive member 562.

In order to expand or reduce a display, an electronic device may include different housings supporting the display. The different housings may be thermally separated by a gap between the different housings. For example, heat generated inside a housing may not be transferred to another housing due to the gap between the housings. In case that the heat is concentrated inside the housing, performance of electronic components in the electronic device may deteriorate. In case that a heat dissipation member integrally formed to thermally connect the different housings is utilized, the heat dissipation member may be damaged due to stress generated by movement of the housings. The electronic device may need a structure capable of dissipating the heat inside the electronic device without damaging by the movement of the housings.

An electronic device (e.g., the electronic device 300 of FIG. 3A, FIG. 3B, and FIG. 3C) according to an embodiment may comprise a hinge structure (e.g., the hinge structure 340 of FIG. 3B and FIG. 3C) including a first hinge plate (e.g., the first hinge plate 343 of FIG. 3B and FIG. 3C), a second hinge plate (e.g., the first hinge plate 344 of FIG. 3B and FIG. 3C) rotatable with respect to the first hinge plate, and a third hinge plate (e.g., the first hinge plate 345 of FIG. 3B and FIG. 3C) distinct from the second hinge plate and rotatable with respect to the first hinge plate. According to an embodiment, the electronic device may comprise a display (e.g., the display 330 of FIG. 3B and FIG. 3C), disposed on the hinge structure, foldable by movement of the second hinge plate and the third hinge plate with respect to the first hinge plate. According to an embodiment, the electronic device may comprise a layer (e.g., the layer 350 of FIG. 3A, FIG. 3B, and FIG. 3C), attached to the display, including a first heat dissipation member (e.g., the first heat dissipation member 351 of FIG. 3A, FIG. 3B, and FIG. 3C) that includes a first segment (e.g., the first segment 351a of FIG. 3A, FIG. 3B, and FIG. 3C), a second segment (e.g., the second segment 351b of FIG. 3A, FIG. 3B, and FIG. 3C) spaced apart from the first segment, and a plurality of third segments (e.g., the plurality of third segments 351c of FIG. 3A, FIG. 3B, and FIG. 3C) disposed between the first segment and the second segment and spaced apart from each other. According to an embodiment, the electronic device may comprise a first conductive member (e.g., the first conductive member 360 of FIG. 3B and FIG. 3C) attached on a surface of the first hinge plate facing the plurality of third segments. According to an embodiment, in an unfolded state of the electronic device in which a direction in which a surface (e.g., the surface 344a of FIG. 3B and FIG. 3C) of the second hinge plate faces is the same as a direction in which a surface (e.g., the surface 345a of FIG. 3B and FIG. 3C) of the third hinge plate faces, when the display is viewed in a second direction opposite to a first direction in which the surface of the first hinge plate faces, the first conductive member may overlap a portion of the first segment and a portion of the second segment.

The electronic device according to an embodiment may provide a structure capable of thermally connecting the first housing and the second housing despite repetition of a change in a state of the electronic device by the first heat dissipation member including a plurality of segments separated from each other. The electronic device according to an embodiment may provide a structure capable of dissipating heat generated in the first housing to the second housing by the first conductive member overlapping the first segment and the second segment in the unfolded state of the electronic device.

According to an embodiment, the layer may include a first deformation member (e.g., the first deformation member 352 of FIG. 3B and FIG. 3C), extending across the hinge structure, being in contact with a surface of the first heat dissipation member facing the display. According to an embodiment, the layer may include a second deformation member (e.g., the second deformation member 353 of FIG. 3B and FIG. 3C), extending across the hinge structure, being in contact with another surface of the first heat dissipation member opposite to the surface of the first heat dissipation member.

The electronic device according to an embodiment may provide the structure capable of thermally connecting the first housing and the second housing despite the repetition of the change in the state of the electronic device by the first deformation member connecting segments of the first heat dissipation member and the second deformation member.

According to an embodiment, a gap between the plurality of third segments may change as the display is folded or unfolded by the second hinge plate and the third hinge plate.

As a size of the gap between the plurality of third segments reduces or expands according to the state of the electronic device, the electronic device according to an embodiment may provide a structure capable of reducing damage to the first heat dissipating member due to stress generated by the change in the state of the electronic device.

According to an embodiment, another portion of the first segment may face the second hinge plate. According to an embodiment, another portion of the second segment may face the third hinge plate.

The electronic device according to an embodiment may provide a structure in which the first housing and the second housing are thermally connected by the first segment facing the second hinge plate and the second segment facing the third hinge plate.

According to an embodiment, the first conductive member may be deformable by the layer when the display is deformed.

Since the first conductive member is deformable, the electronic device according to an embodiment may provide a structure capable of reducing damage to the display.

According to an embodiment, the layer may have a shape corresponding to a shape of the display.

Since the layer is deformable, the electronic device according to an embodiment may provide a structure capable of reducing damage to the layer due to the stress generated by the change in the state of the electronic device.

According to an embodiment, a width of the first conductive member may be greater than a width of the plurality of third segments.

The electronic device according to an embodiment may provide the structure in which the first housing and the second housing are thermally connected by the first conductive member having the width greater than the width of the plurality of third segments.

According to an embodiment, the electronic device may comprise a first housing (e.g., the first housing 310 of FIG. 3B and FIG. 3C) including a first surface (e.g., the first surface 311 of FIG. 3B and FIG. 3C) supporting a portion of the display and a second surface (e.g., the second surface 212 of FIG. 2A, FIG. 2B, and FIG. 2C) opposite to the first surface. According to an embodiment, the electronic device may comprise a second housing (e.g., the second housing 320 of FIG. 3B and FIG. 3C), including a third surface (e.g., the third surface 321 of FIG. 3B and FIG. 3C) supporting another portion of the display and a fourth surface (e.g., the fourth surface 222 of FIG. 2A, FIG. 2B, and FIG. 2C) opposite to the third surface, coupled to the first housing through the hinge structure so as to be rotatable with respect to the first housing. According to an embodiment, the layer may be disposed on the first surface and the third surface across the hinge structure.

Since the layer extends on the first housing and the second housing across the hinge structure, the electronic device according to an embodiment may provide the structure in which the first housing and the second housing are thermally connected.

According to an embodiment, the second housing may be rotatable with respect to the first housing within a first angle range. According to an embodiment, the second hinge plate may be rotatable with respect to the first hinge plate within a second angle range greater than the first angle range.

Since the second hinge plate and the second housing have different rotation angles, the electronic device according to an embodiment may provide a structure in which a change in curvature of the display is gradual.

According to an embodiment, the surface of the second hinge plate may be inclined with respect to the first surface in a folded state of the electronic device in which the first surface and the third surface face each other.

Since the second hinge plate and the first housing are inclined in the folded state of the electronic device, the electronic device according to an embodiment may provide the structure in which the change in curvature of the display is gradual.

According to an embodiment, the electronic device may comprise a second heat dissipation member (e.g., the second heat dissipation member 410 of FIG. 4A and FIG. 4B), disposed on the surface of the second hinge plate, spaced apart from the layer. According to an embodiment, the electronic device may comprise a second conductive member (e.g., the second conductive member 430 of FIG. 4A and FIG. 4B), interposed between the layer and the second heat dissipation member, facing the first segment.

The electronic device according to an embodiment may provide a structure in which a path through which heat generated in the first housing can move is expanded by the second heat dissipation member and the second conductive member.

According to an embodiment, the electronic device may comprise a first housing (e.g., the first housing 310 of FIG. 3B and FIG. 3C) supporting a portion of the display. According to an embodiment, the electronic device may comprise a second housing (e.g., the second housing 320 of FIG. 3B and FIG. 3C), supporting another portion of the display, coupled to the first housing through the hinge structure so as to be rotatable with respect to the first housing. According to an embodiment, the second heat dissipation member may extend from the first housing to the surface of the second hinge plate.

Since the second heat dissipation member is disposed on the first housing, the electronic device according to an embodiment may provide the structure in which the path through which the heat generated in the first housing can move is expanded.

According to an embodiment, the electronic device may comprise a third heat dissipation member (e.g., the third heat dissipation member 420 of FIG. 4A and FIG. 4B), disposed on the surface of the third hinge plate, spaced apart from the layer. According to an embodiment, the electronic device may comprise a third conductive member (e.g., the third conductive member 440 of FIG. 4A and FIG. 4B), interposed between the layer and the third heat dissipation member, facing the second segment.

The electronic device according to an embodiment may provide a structure in which a path through which heat generated in the second housing can move is expanded by the third heat dissipation member and the third conductive member.

According to an embodiment, the electronic device may comprise a first housing (e.g., the first housing 310 of FIG. 3B and FIG. 3C) supporting a portion of the display. According to an embodiment, the electronic device may comprise a second housing (e.g., the second housing 320 of FIG. 3B and FIG. 3C), supporting another portion of the display, coupled to the first housing through the hinge structure so as to be rotatable with respect to the first housing. According to an embodiment, the third heat dissipation member may extend from the second housing to the surface of the third hinge plate.

Since the third heat dissipation member is disposed on the second housing, the electronic device according to an embodiment may provide the structure in which the path through which the heat generated in the second housing can move is expanded.

According to an embodiment, the electronic device may comprise a fourth heat dissipation member (e.g., the fourth heat dissipation member 450 of FIG. 4A and FIG. 4B) interposed between the first conductive member and the surface of the first hinge plate.

The electronic device according to an embodiment may provide a structure in which a path through which the heat can move on the hinge structure is expanded by the fourth heat dissipation member.

An electronic device (e.g., the electronic device 300 of FIG. 3A, FIG. 3B, and FIG. 3C) according to an embodiment may comprise a hinge structure (e.g., the hinge structure 540 of FIG. 5A and FIG. 5B) including a hinge bracket (e.g., the hinge bracket 542 of FIG. 5A and FIG. 5B), a first hinge plate (e.g., the first hinge plate 543 of FIG. 5A and FIG. 5B), rotatable with respect to the hinge bracket, and a second hinge plate (e.g., the second hinge plate 544 of FIG. 5A and FIG. 5B) distinct from the first hinge plate and rotatable with respect to the hinge bracket. According to an embodiment, the electronic device may comprise a display (e.g., the display 330 of FIG. 3A and FIG. 3B), disposed on the hinge structure, being foldable by movement of the first hinge plate and the second hinge plate with respect to the hinge bracket. According to an embodiment, the electronic device may comprise a layer (e.g., the layer 350 of FIG. 3A, FIG. 3B, and FIG. 3C), attached to the display, including a first heat dissipation member (e.g., the first heat dissipation member 351 of FIG. 3A, FIG. 3B, and FIG. 3C) that includes a first segment (e.g., the first segment 351a of FIG. 3A, FIG. 3B, and FIG. 3C), a second segment (e.g., the second segment 351b of FIG. 3A, FIG. 3B, and FIG. 3C) spaced apart from the first segment, and a plurality of third segments (e.g., the plurality of third segments 351c of FIG. 3A, FIG. 3B, and FIG. 3C) disposed between the first segment and the second segment, and spaced apart from each other. According to an embodiment, the electronic device may comprise a first conductive member (e.g., the fourth conductive member 561 of FIG. 5A and FIG. 5B) attached on a surface (e.g., the surface 543a of FIG. 5A and FIG. 5B) of the first hinge plate facing the layer. According to an embodiment, the electronic device may comprise a second conductive member (e.g., the fifth conductive member 562 of FIG. 5A and FIG. 5B) attached on a surface (e.g., the surface 544a of FIG. 5A and FIG. 5B) of the second hinge plate facing the layer. According to an embodiment, in an unfolded state of the electronic device in which a direction in which the surface of the first hinge plate faces is the same as a direction in which the surface of the second hinge plate faces, when the display is viewed in a second direction opposite to a first direction in which the surface of the first hinge plate faces, some (e.g., the some 351c-1 of FIG. 5A and FIG. 5B) of the plurality of third segments may at least partially overlap the first conductive member and the second conductive member.

The electronic device according to an embodiment may provide a structure capable of dissipating heat generated in the electronic device by the some of the plurality of third segments thermally connecting the fourth conductive member and the fifth conductive member.

According to an embodiment, the electronic device may comprise a second heat dissipation member (e.g., the fifth heat dissipation member 551 of FIG. 5A and FIG. 5B) disposed between the first conductive member and the first hinge plate. According to an embodiment, the electronic device may comprise a third heat dissipation member (e.g., the sixth heat dissipation member 552 of FIG. 5A and FIG. 5B), spaced apart from the second heat dissipation member, disposed between the second conductive member and the second hinge plate.

The electronic device according to an embodiment may provide a structure in which a path through which heat can move between the first housing and the second housing is expanded by the fifth heat dissipation member and the sixth heat dissipation member.

According to an embodiment, the layer may include a first deformation member (e.g., the first deformation member 352 of FIG. 3B and FIG. 3C), extending across the hinge structure, being in contact with a surface of the first heat dissipation member facing the display. According to an embodiment, the layer may include a second deformation member (e.g., the second deformation member 353 of FIG. 3B and FIG. 3C), extending across the hinge structure, being in contact with another surface of the first heat dissipation member opposite to the surface of the first heat dissipation member.

The electronic device according to an embodiment may provide a structure capable of thermally connecting the first housing and the second housing despite repetition of a change in the state of the electronic device by the first deformation member and the second deformation member, connecting segments of the first heat dissipation member.

According to an embodiment, the electronic device may comprise a first housing (e.g., the first housing 310 of FIG. 3B and FIG. 3C) including a first surface (e.g., the first surface 311 of FIG. 3B and FIG. 3C) supporting a portion of the display and a second surface (e.g., the second surface 212 of FIG. 2A, FIG. 2B, and FIG. 2C) opposite to the first surface. According to an embodiment, the electronic device may comprise a second housing (e.g., the second housing 320 of FIG. 3B and FIG. 3C), including a third surface (e.g., the third surface 321 of FIG. 3B and FIG. 3C) supporting another portion of the display and a fourth surface (e.g., the fourth surface 222 of FIG. 2A, FIG. 2B, and FIG. 2C) opposite to the third surface, coupled to the first housing through the hinge structure so as to be rotatable with respect to the first housing. According to an embodiment, the surface of the first hinge plate may be inclined with respect to the surface of the second hinge plate in a folded state of the electronic device in which the first surface and the third surface face each other.

Since the second hinge plate is inclined with respect to the first hinge plate in the folded state of the electronic device, the electronic device according to an embodiment may provide a structure in which a change in curvature of the display is gradual.

According to an embodiment, the electronic device may comprise a first reinforcement member (e.g., the first reinforcement member 571 of FIG. 5A and FIG. 5B) disposed between the first surface and the layer. According to an embodiment, the electronic device may comprise a second reinforcement member (e.g., the second reinforcement member 572 of FIG. 5A and FIG. 5B) disposed between the third surface and the layer.

The electronic device according to an embodiment may provide a structure capable of protecting the display from an external impact of the electronic device by the first reinforcement member and the second reinforcement member.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101; 200; 300) comprising:
a hinge structure (340) including a first hinge plate (343), a second hinge plate (344) rotatable with respect to the first hinge plate (343), and a third hinge plate (345) rotatable with respect to the first hinge plate (343);
a display (330), disposed on the hinge structure (340), foldable by movement of the second hinge plate (344) and the third hinge plate (345) with respect to the first hinge plate (343);
a layer (350), attached to the display (330), including a first heat dissipation member (351) that includes a first segment (351a), a second segment (351b) spaced apart from the first segment (351a), and a plurality of third segments (351c) disposed between the first segment (351a) and the second segment (351b) and spaced apart from each other; and
a first conductive member (360) attached on a surface (343a) of the first hinge plate (343) facing the plurality of third segments (351c),
wherein, in an unfolded state of the electronic device (101; 200; 300) in which a direction in which a surface (344a) of the second hinge plate (344) faces is the same as a direction in which a surface (345a) of the third hinge plate (345) faces, when the display (330) is viewed in a second direction opposite to a first direction in which the surface (343a) of the first hinge plate (343) faces, the first conductive member (360) overlaps a portion of the first segment (351a) and a portion of the second segment (351b).

2. The electronic device (101; 200; 300) of claim 1,
wherein the layer (350) further includes:
a first deformation member (352), extending across the hinge structure (340), being in contact with a surface of the first heat dissipation member (351) facing the display (330); and
a second deformation member (353), extending across the hinge structure (340), being in contact with another surface of the first heat dissipation member (351) opposite to the surface of the first heat dissipation member (351).

3. The electronic device (101; 200; 300) of any one of claims 1 and 2,
wherein a gap between the plurality of third segments (351c) changes as the display (330) is folded or unfolded by the second hinge plate (344) and the third hinge plate (345).

4. The electronic device (101; 200; 300) of any one of claims 1 to 3,
wherein another portion of the first segment (351a) faces the second hinge plate (344), and
wherein another portion of the second segment (351b) faces the third hinge plate (345).

5. The electronic device (101; 200; 300) of any one of claims 1 to 4,
wherein the first conductive member (360) is deformable by the layer (350) when the display (330) is deformed.

6. The electronic device (101; 200; 300) of any one of claims 1 to 5,
wherein the layer (350) has a shape corresponding to a shape of the display (330).

7. The electronic device (101; 200; 300) of any one of claims 1 to 6,
wherein a width of the first conductive member (360) is greater than a width of the plurality of third segments (351c).

8. The electronic device (101; 200; 300) of any one of claims 1 to 7, further comprising:
a first housing (310) including a first surface (311) supporting a portion of the display (330) and a second surface opposite to the first surface (311); and
a second housing (320), including a third surface (321) supporting another portion of the display (330) and a fourth surface opposite to the third surface (321), coupled to the first housing (310) through the hinge structure (340) so as to be rotatable with respect to the first housing (310),
wherein a portion of the layer (350) is disposed on the first surface (311) and the third surface (321) across the hinge structure (340).

9. The electronic device (101; 200; 300) of any one of claims 1 to 8,
wherein the second housing (320) is rotatable with respect to the first housing (310) within a first angle range, and
wherein the second hinge plate (344) is rotatable with respect to the first hinge plate (343) within a second angle range greater than the first angle range.

10. The electronic device (101; 200; 300) of any one of claims 1 to 9,
wherein the surface of the second hinge plate (344) is inclined with respect to the first surface (311) in a folded state of the electronic device (101; 200; 300) in which the first surface (311) and the third surface (321) face each other.

11. The electronic device (101; 200; 300) of any one of claims 1 to 10, further comprising:
a second heat dissipation member (410), disposed on the surface of the second hinge plate (344), spaced apart from the layer (350); and
a second conductive member (440), interposed between the layer (350) and the second heat dissipation member (410), facing the first segment (351a).

12. The electronic device (101; 200; 300) of any one of claims 1 to 11, further comprising:
a first housing (310) supporting a portion of the display (330); and
a second housing (320), supporting another portion of the display (330), coupled to the first housing (310) through the hinge structure (340) so as to be rotatable with respect to the first housing (310),
wherein the second heat dissipation member (410) extends from the first housing (310) to the surface (344a) of the second hinge plate (344).

13. The electronic device (101; 200; 300) of any one of claims 1 to 12, further comprising:
a third heat dissipation member (420), disposed on the surface (345a) of the third hinge plate (345), spaced apart from the layer (350); and
a third conductive member (450), interposed between the layer (350) and the third heat dissipation member (420), facing the second segment (351b).

14. The electronic device (101; 200; 300) of any one of claims 1 to 13, further comprising:
a first housing (310) supporting a portion of the display (330); and
a second housing (320), supporting another portion of the display (330), coupled to the first housing (310) through the hinge structure (340) so as to be rotatable with respect to the first housing (310),
wherein the third heat dissipation member (420) extends from the second housing (320) to the surface (345a) of the third hinge plate (345).

15. The electronic device (101; 200; 300) of any one of claims 1 to 14, further comprising:
a fourth heat dissipation member (430) interposed between the first conductive member (360) and the surface (343a) of the first hinge plate (343).
